Europäisches Patentamt

European Patent Office

Office européen des brevets

(11) Publication number: **0 215 270 B1**

(12) **EUROPEAN PATENT SPECIFICATION**

(45) Date of publication of patent specification: **30.12.92**   (51) Int. Cl.⁵: **G11B  5/39**

(21) Application number: **86110796.9**

(22) Date of filing: **05.08.86**

(54) **Method and apparatus for reading recorded data by a magnetoresistive head.**

(30) Priority: **20.08.85 US 767549**

(43) Date of publication of application:
**25.03.87 Bulletin  87/13**

(45) Publication of the grant of the patent:
**30.12.92 Bulletin  92/53**

(84) Designated Contracting States:
**DE FR GB IT**

(56) References cited:
**EP-A- 0 053 343      EP-A- 0 154 307**
**GB-A- 2 019 638      GB-A- 2 023 326**
**US-A- 3 418 163      US-A- 4 040 113**
**US-A- 4 191 977**

**J. G. Graeme, G. E. Tobey, L. P. Huelsman:
Operational Amplifiers, Design and Applications, pages 208 to 213**

(73) Proprietor: **International Business Machines
Corporation
Old Orchard Road
Armonk, N.Y. 10504(US)**

(72) Inventor: **Klaassen, Klaas Berend
7171 Anjou Circle
San Jose CA 95120(US)**

(74) Representative: **Blakemore, Frederick Norman
IBM United Kingdom Limited Intellectual
Property Department Hursley Park
Winchester Hampshire SO21 2JN(GB)**

EP 0 215 270 B1

## Description

The present invention relates to retrieval of previously stored data, including data recorded in magnetic media and data stored in magnetic bubble memories, by a magnetoresistive (MR) read head or sensor.

An MR head is an active or parametric transducer which requires an electrical current through its resistive sensor stripe to be active. The current serves as a sensing current for converting the stripe resistance variations produced by the field, Hy, emanating from the medium into voltage variations across the stripe.

The higher the current applied to the head, the larger the readout voltage. The magnitude of the current, however, must be limited to avoid overheating the sensor stripe, and to avoid electromigration of the stripe material. This current should be provided from a low noise source to minimise noise injected into the read channel electronics.

Most existing MR head preamplifiers bias the sensor stripe of the head at a constant bias current, $I_b$, and detect the signal voltage, $V_s$, developed at the head terminals. Thus,

$$V_s = I_b \Delta R_h, \qquad (A)$$

where $\Delta R_h$ is the absolute change in the head resistance, $R_h$, owing to the magnetic input signal, $H_y$, from the media being read.

Stripe height, the dimension of the sensing stripe perpendicular to the media will vary from device to device because of variations in the lapping process. Stripe height also changes as much as 50% over the life of an MR head in contact recording applications. Since both $R_h$ and, more importantly, $\Delta R_h$ are proportional to stripe height prior art preamplifiers which detect $V_s$ of equation (A) provide different sensisity if switched from one head to another in a multihead storage device or, in contact recording devices, as the stripe height is worn away. Similarly, different sensitivities would be encountered when switching from one sensor to another in bubble memory systems.

Moreover, $R_n$ typically exhibits a temperature coefficient of about 0.3 to 0.5% per degree C. Thus, as temperature varies, $R_h$ varies according to its particular temperature coefficient. The corresponding variation in $\Delta R_h$ causes low frequency noise modulation of the output signal, $V_s$.

US-A-3,814,863 describes one prior art configuration which proposes biasing an MR head using resistors having large values with respect to the value of $R_h$, and an AC coupled differential voltage amplifier . IN another described in US-A-4,040,113 a current source used for biasing a centre-tapped MR element and an AC coupled differential voltage amplifier for detecting the output signal produced by the head. Finally, US-A-4,191,977 described a method of biasing a centre-tapped MR head using two inductors in series with the head and a voltage source with a DC coupled differential voltage amplifier.

The prior art hereinbefore described teaches biasing the MR head with a constant bias current and detecting the signal produced across the head with a differential voltage amplifier. The detected signal, therefore, which is proportional to $\Delta R_h$, is sensitive to production tolerances, contact recording wear, and temperature variations.

GB 2 023 326 describes a circuit for detecting magnetic fields having encoded information to produce electrical signals representing the encoded information. The circuit comprises a magnetoresistive element and detection means. The detection means detects the ratio of the instantaneous value of the change in the resistance of the magnetoresistive element to the absolute magnetoresistive element resistance.

In accordance with the present invention, there is now provided a circuit for detecting magnetic fields having encoded information to produce electrical signals representing the encoded information, the circuit comprising: a magnetoresistive element; and detection means for detecting the ratio of the instantaneous value of the change in the resistance of the magnetoresistive element to the absolute magnetoresistive element resistance; characterised in that the detection means comprises: first and second current sources connected in series with the magnetoresistive element for generating a bias current in the magnetoresistive element; a capacitor connected across the magnetoresistive element; a current probe for detecting a current deviation from the bias current, the deviation being proportional to the relative resistance change of the magnetoresistive element produced by exposing the magnetoresistive element to the magnetic field, the current probe generating a signal voltage proportional to the deviation.

Viewing the present invention from a second aspect, there is provided a circuit for detecting magnetic fields having encoded information to produce electrical signals representing the encoded information, the circuit comprising: a magnetoresistive element; and detection means for detecting the ratio of the instantaneous value of the change in the resistance of the magnetoresistive element to the absolute magnetoresistive element resistance; characterised in that the detection means comprises: a constant voltage source connected to first and second matched resistors in series with the magnetoresistive element to generate a bias current through the magnetoresistive element; and a ferrite toroid having primary and secondary windings, the primary winding being connected in series with the magnetoresistive element to generate current deviations in the primary winding, deviations being proportional to the relative resistance change of the magnetoresistive element produced, the deviations generating a signal voltage across the secondary winding, the signal voltage being proportional to the deviations.

Viewing the present invention from a third aspect, there is provided a circuit for detecting magnetic fields having encoded information to produce electrical signals representing the encoded information, the circuit comprising:
a magnetoresistive element; detection means for detecting the ratio of the instantaneous value of the change in the resistance of the magnetoresistive element to the absolute magnetoresistive element resistance; characterised in that the detection means includes: a current source connected in series with the magnetoresistive element having a resistance Rh for generating a bias current Ib in the magnetoresistive element; and a detector for detecting current deviations from the bias current, the deviations being proportional to the relative resistance change $\triangle R_h$ of the magnetoresistive element produced by exposing the element to the magnetic fields, the detector comprising a differential amplifier for amplifying the instantaneous value of the current deviations, Is, of the current deviations, substantially according to the relation

$$I_s = I_b \frac{\triangle R_h}{R_h}$$

where Ib is the bias current, $R_h$ is the absolute resistance of the magnetoresistive element, and $\triangle R_h$ is the instantaneous value of the change in the resistance of the magnetoresistive element in the presence of the magnetic field, the differential amplifier having one input coupled to a reference voltage and the other input connected in series with magnetoresistive element to generate an output signal voltage which is proportional to the deviations, and further including a capacitance having one terminal connected to the magnetoresistive element and said other input of the amplifier and the other terminal connected to the reference voltage.

Viewing the present invention from a fourth aspect, there is provided a circuit for detecting magnetic fields having encoded information to produce electrical signals representing the encoded information, the circuit comprising:
a magnetoresistive element; detection means for detecting the ratio of the instantaneous value of the change in the resistance of the magnetoresistive element to the absolute magnetoresistive element resistance $R_h$; characterised in that the detection means includes: a controlled constant current source connected to the magnetoresistive element to generate a current, $I_{b'}$ therethrough; a detector for detecting deviations of the voltage across the magnetoresistive element from the constant voltage, $V_b$, provided by a constant voltage source, the deviations being proportional to the relative resistance change of the magnetoresistive element produced by exposing the element to the magnetic fields, the detector comprising a voltage amplifier for amplifying the instantaneous value, $V_s$, of the deviations substantially according to the relation

$$V_s = V_b \frac{\triangle R_h}{R_h}$$

where $V_b$ is the voltage provided by the constant voltage source, $R_h$ is the absolute resistance of the magnetoresistive element, and $\triangle R_h$ is the instantaneous value of the change in the resistance of the magnetoresistive element in the presence of the magnetic field, and further comprising a bias feedback loop for minimising the steady state voltage across the inputs of the voltage amplifier.

Biasing and detection of the signal produced by an MR head, centre-tapped or not, according to the principles of the present invention may be biased by either a constant current or constant voltage source.

For a constant current configuration, MR stripe resistance, $R_h$, is biased by a DC current, $I_b$. Current variations, proportional to the instantaneous value of the relative change, $\triangle R_h/R_h$ as the head detects variations in the magnetisation of the recording medium representing data, can then be applied to the input of a current sensing differential preamplifier.

In a constant DC voltage configuration instantaneous value of voltage variations produced by the MR head as it detects data recorded in a magnetic medium can be applied to the input of a voltage sensing differential preamplifier. In either the constant current or constant voltage biasing configurations only the instantaneous value of AC signal, ie the change, produced by the MR head is detected and conditioned by the differential preamplifier.

It can be seen the instantaneous value of signal produced by the MR head in these configurations is proportional to $\triangle R_h/R_h$. As both $R_h$ and $\triangle R_h$ are proportional to stripe height and to temperature changes in the same way $\Delta R_h/R_h$ is independent of stripe height and temperature variations. By normalising in this way the signal produced by the MR head, variations in the value of $R_h$ arising in such heads because of manufacturing tolerances and temperature sensitivity are therefore intrinsically corrected. It has also been found that detecting $\Delta R_h/R_h$ not only corrects fully, for variations in stripe lengths, but also substantially corrects for variations in stripe thickness. Thus, in a multiple head memory device, for example, switching the signal conditioning circuitry from one head to another, does not require adjustment of the signal conditioning electronics to different levels of gain to accommodate varying detection sensitivities of the heads involved.

A number of embodiments of the invention as well as one prior art arrangement are described in the following with reference to the accompanying drawings in which:

Figure 1 is a block diagram of one typed prior art MR head biasing and output signal detection;

Figure 2A is a block diagram of one embodiment of the present invention employing constant current biasing;

Figure 2B is a block diagram of another embodiment employing constant current biasing;

Figure 3 is block diagram of an embodiment of the present invention employing a single-ended configuration;

Figure 4 is a block diagram of a further embodiment of the invention employing a pseudo-balanced configuration; and

Figure 5 is a block diagram of an embodiment of the invention employing constant voltage biasing.

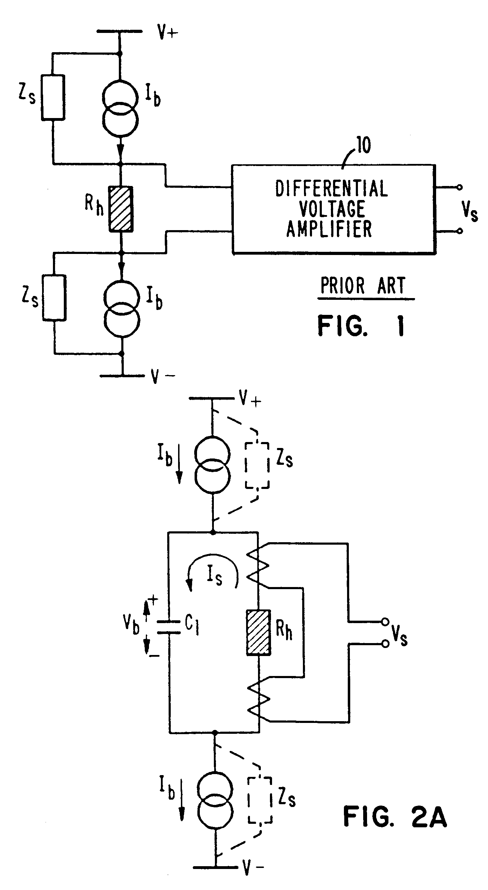

Referring first to Figure 1, constant bias current, $I_b$, is supplied to MR head, $R_h$, employed, for example, in a read/write channel for reading data recorded in magnetic media. Impedances Z are the internal impedances of the bias current source. Since voltage amplifier 10 detects the head voltage, $V_s$, given by Equation (A) where $\Delta R_h$ is the absolute change in head resistance $R_h$. The amplifier output, $V_s$, is therefore proportional to $\Delta R_h$. Hence, all other factors causing changes in $R_h$ are also detected. Such other factors interfere with detecting only those changes in $R_h$ which are caused by data bits recorded on a magnetic medium. The large DC voltage component produced by the constant current flowing through $R_h$ may be removed by AC coupling capacitors at the input of amplifier 10.

Since the magnitude of $\Delta R_h$ caused by a certain magnetic excitation is directly proportional to MR head resistance $R_h$, the output signal of amplifier 10 changes as $R_h$ changes with temperature. The temperature coefficient of a typical MR head resistance comprising a permalloy stripe is in the range from 0.3 to 0.5% per degree C. Thus, as much as 10% change in output voltage of amplifier 10 is produced for every 20 degrees C of ambient temperature change. Since biasing and sensitivity of the MR head is also dependent on production tolerances in $R_h$, adjustment of the bias current for individual heads to obtain the same specified read mode sensitivity of the channel would be required.

Figure 2A illustrates an embodiment of the present invention. In this, the MR head is biased by a constant DC current, $I_b$. $Z_s$ is the internal source impedance of the current sources, $I_b$ where $|Z_s| >> R_h$. AC current variations such as noise, line hum, and the like, produced by the current sources, $I_b$, or supply voltage V+ and V-, are shorted out by capacitor $C_1$. $C_1$ is large enough so that,

$$1/2\, \Pi\, R_h\, C_1 << F_0,$$

where $F_0$ is the lowest frequency of interest in the signal detection channel.

Dynamic variation of the head resistance from $R_h$ to $R_h + \Delta R_h$ produces a signal current, $I_s$, to flow in the $R_h C_1$ circuit. Any current sensor, such as a toroid current probe transformer can be used to detect $I_s$. Thus, from

$$I_s + \frac{V_b}{R_h + \Delta R_h} = \frac{V_b}{R_h} = I_b,$$

it follows that

$$I_s = I_b \frac{\Delta R_h}{R_h + \Delta R_h}.$$

If $\Delta R_h$ is small with respect to $R_h$, then

$$I_s \cong I_b \Delta R_h / R_h,$$

and output signal, $V_s$, is given by

$$V_s \cong K I_b \Delta R_h / R_h, \qquad (1)$$

where K is the sensitivity of the current sensor.

Thus, the configuration shown in Figure 2A detects a current proportional to the relative resistance change, $\Delta R_h/R_h$. Since the temperature coefficient is cancelled by this technique, $V_s$ is substantially insensitive to temperature changes to which the MR head is subjected. Detection of a voltage proportional to relative resistance change is also insensitive to production tolerances affecting the value of $R_h$. Therefore, $I_b$ need not be adjusted for uniform sensitivity from one head to another, and read mode sensitivity is independent of resistance variations arising during the manufacturing process, or owing to wear during the life of the head in contact recording applications. As shown earlier in this specification, $C_1$ is selected for shorting out noise current produced by the biasing network yet does not limit the bandwidth of the data signals produced by the MR head. Other interference sources at the head/media interface, which cause interference current to flow into or out of the two head terminals, are cancelled by the differential current sensing shown in Figure 2A. Therefore, this arrangement provides high rejection of common-mode interference.

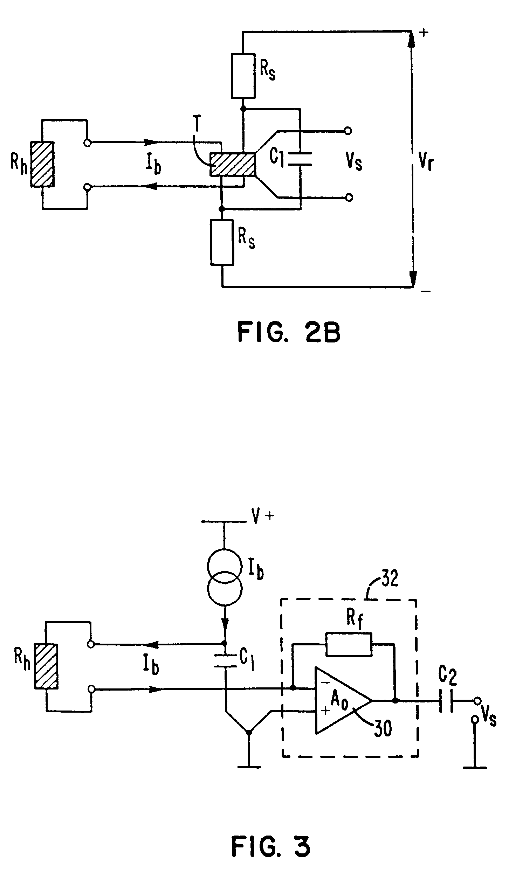

In Figure 2B, $I_b$ is derived from a reference voltage, $V_r$, via matched resistors, $R_s$. If $R_s$ is much greater than $R_h$, the bias current is given by

$$I_b = V_r/2R_s.$$

Toroid, T, is a ferrite toroid having, any suitable number of recording windings, and a primary winding found by the head leads which are fed thru the toroid so that head signal current adds and common mode currents cancel. Thus, for this configuration according to equation (1), if $K = 10mv/mA$, $I_b = 10$ mA, $\Delta R_h/R_h = 0.5\%$, then $V_s = 500 \mu v$.

Referring now to Figure 3, a single-ended configuration of the present invention is shown. In this circuit, one side of $R_h$ is grounded by $C_1$ at one input of differential amplifier 30. The combination of amplifier 30 and $R_f$ is current sensing amplifier 32. Coupling capacitor $C_2$ removes the DC component from the output signal, $V_s$. Thus,

$$V_s = I_b R_f(\Delta R_h/R_h).$$

For the configuration of Figure 3, if $R_h$ is 50 ohms and $\Delta R_h/R_h = 0.5\%$, $R_f$ is 500 ohms, C1 is 0.5 $\mu F$, C2 is 0.1 $\mu F$ and amplifier 30 is a wideband amplifier, then $V_s$ is 25 mV at $F_0 = 6$ kHz.

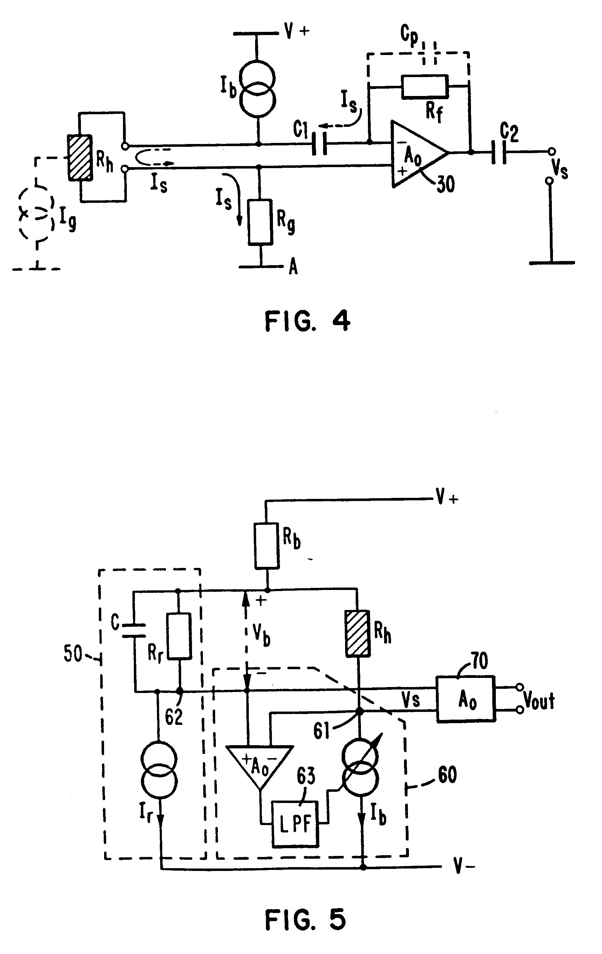

The pseudo-balanced configuration of Fig. 4 is useful in the presence of undesirable stray ground currents which may be injected into the MR head sensing stripe through the slider-to-stripe capacitance. One-half of the injected ground current, $I_g$, will flow through grounding resistor, $R_g$. The other half of $I_g$ will flow through feedback resistor, $R_f$. If $R_g$ and $R_f$ are matched or otherwise substantially equal, the voltage developed by the flow of one-half $I_g$ through each of these resistors will be cancelled at the amplifier output since they are of opposite phase. Thus, stray ground current, $I_g$, does not contaminate $V_s$.

For the configuration of Fig. 4, if $R_h$ changes by an amount $\Delta R_h$, the resulting signal current is given by

$$I_s = -I_b(\Delta R_h/R_h).$$

Current $I_s$ is supplied from feedback resistor $R_f$ and flows through $R_g$ to ground. Thus,

$$V_s = -2I_b R_f(\Delta R_h/R_h).$$

For the configuration of Fig. 4, with $I_b = 10$ mA, $\Delta R_h/R_h = 0.5\%$, $I_s = 50 \mu A$ and $V_s = -50$ mV if $C_1 = 0.5 \mu F$, $C_2 = 0.1 \mu F$, $R_f = 500$ ohms and amplifier 30 is a wideband amplifier, such as an MC1733, manufactured by Motorola.

Referring now to Fig. 5, where an embodiment for constant voltage biasing of an MR head according to the present invention is shown, model reference 50 comprises a fixed current source, $I_r$, a resistor, $R_r$ and capacitor, C. Voltage $V_b$, given by the product of $I_r$ and $R_r$, provides the reference for bias voltage across MR head resistor, $R_h$. Since capacitor C forms a short circuit for all data frequencies, the input of voltage amplifier 70 is effectively coupled across MR head resistance, $R_h$. Capacitor C also shorts out all noise produced by resistor $R_r$. Thus, signal amplifier 70 detects and amplifies the instantaneous value of the voltage, $V_s$, produced by the MR head according to the relation

$$V_s = V_b \frac{\Delta R_h}{R_h}.$$

Bias feedback loop 60 offsets $V_b$ by driving the potential of $R_h$ lead 61 to the same potential as $R_r$ lead 62. The operating frequency range of bias feedback loop 60 is determined by low pass filter 63 which is designed to pass only DC and very low frequencies.

## Claims

1. A circuit for detecting magnetic fields having encoded information to produce electrical signals representing the encoded information, the circuit comprising:
   a magnetoresistive element; and
   detection means for detecting the ratio of the instantaneous value of the change in the resistance of the magnetoresistive element to the absolute magnetoresistive element resistance;

characterised in that the detection means comprises:

first and second current sources connected in series with the magnetoresistive element for generating a bias current ($I_b$) in the magnetoresistive element ($R_h$);

a capacitor (C1) connected across the magnetoresistive element ($R_h$);

a current probe for detecting a current deviation from the bias current, the deviation being proportional to the relative resistance change of the magnetoresistive element produced by exposing the magnetoresistive element to the magnetic field, the current probe generating a signal voltage ($V_s$) proportional to the deviation (Figure 2A).

2.    A circuit for detecting magnetic fields having encoded information to produce electrical signals representing the encoded information, the circuit comprising:

a magnetoresistive element ($R_h$); and

detection means for detecting the ratio of the instantaneous value of the change in the resistance of the magnetoresistive element to the absolute magnetoresistive element resistance;

characterised in that the detection means comprises:

a constant voltage source ($V_r$) connected to first and second matched resistors ($R_s$) in series with the magnetoresistive element ($R_h$) to generate a bias current through the magnetoresistive element ($R_h$); and

a ferrite toroid (T) having primary and secondary windings, the primary winding being connected in series with the magnetoresistive element to generate current deviations in the primary winding, the deviations being proportional to the relative resistance change of the magnetoresistive element produced, the deviations generating a signal voltage ($V_s$) across the secondary winding, the signal voltage being proportional to the deviations (Figure 2B).

3.    A circuit as claimed in claim 2 further including a capacitance (C1) connected across the magnetoresistive element to limit spurious signal current variations at frequencies greater than the break point frequency defined by the the capacitance and the total magnetoresistive element resistance.

4.    A circuit for detecting magnetic fields having encoded information to produce electrical signals representing the encoded information, the circuit comprising:

a magnetoresistive element;

detection means for detecting the ratio of the instantaneous value of the change in the resistance of the magnetoresistive element to the absolute magnetoresistive element resistance;

characterised in that the detection means includes:

a current source connected in series with the magnetoresistive element having a resistance $R_h$ for generating a bias current $I_b$ in the magnetoresistive element; and

a detector for detecting current deviations from the bias current, the deviations being proportional to the relative resistance change $\triangle Rh$ of the magnetoresistive element produced by exposing the element to the magnetic fields, the detector comprising a differential amplifier (30) for amplifying the instantaneous value of the current deviations, Is, of the current deviations, substantially according to the relation

$$Is = Ib \frac{\triangle Rh}{Rh}$$

where Ib is the bias current, Rh is the absolute resistance of the magnetoresistive element, and $\triangle Rh$ is the instantaneous value of the change in the resistance of the magnetoresistive element in the presence of the magnetic field, the differential amplifier having one input connected to a reference voltage and the other input connected in series with magnetoresistive element to generate an output signal voltage which is proportional to the deviations. and further including a capacitance having one terminal connected to the magnetoresistive element and said other input of the amplifier and the other terminal connected to the reference voltage (Figure 3 and 4).

5.    A circuit for detecting magnetic fields having encoded information to produce electrical signals representing the encoded information, the circuit comprising:

a magnetoresistive element;

detection means for detecting the ratio of the instantaneous value of the change in the resistance of the magnetoresistive element to the absolute magnetoresistive element resistance RH;

characterised in that the detection means includes:

a controlled constant current source connected to the magnetoresistive element to generate a current (Ib) therethrough;

a detector for detecting deviations of the voltage across Rh from the constant voltage Vb, provided by a constant voltage source (50), the deviations being proportional to the relative resistance change of the magnetoresistive element produced by exposing the element to the magnetic fields, the detector comprising a voltage amplifier (70) for amplifying the instantaneous value, Vs, of the deviations, and further comprising a bias feedback loop (60) for minimising the steady state voltage across the inputs of the voltage amplifier, substantially according to the relation

$$Vs = Vb \frac{\triangle Rh}{Rh}$$

where Vb is the voltage provided by the constant voltage source (50), Rh is the absolute resistance of the magnetoresistive element, and $\triangle$Rh is the instantaneous value of the change in the resistance of the magnetoresistive element in the presence of the magnetic field (Figure 5).

6. A circuit as claimed in claim 5 wherein the detection means comprises a model reference having a current source connected in series with a resistor ($R_r$) to generate a reference voltage level ($V_b$) for the bias voltage across the magnetoresistive element.

7. A circuit as claimed in claim 6 wherein the model reference further comprises a capacitor (C) connected across the resistor to reduce spurious voltage variations produced by the resistor ($R_r$).

8. A circuit as claimed in claim 7 wherein the voltage amplifier (70) comprises two inputs, and the detection means further comprises a bias feedback loop for minimising the steady state voltage across the inputs of the voltage amplifier (70), the bias feedback loop (60) comprising a variable current source connected in series with the magnetoresistive element, a comparator for varying the current from the variable current source in response to variations in the voltage across the inputs of the voltage amplifier (70), and a low pass filter (63) coupled between the output of the comparator and the control input of the variable current source to limit the frequency response bandwidth of the bias feedback loop (60).

**Patentansprüche**

1. Schaltung zum Erfassen magnetischer Felder mit codierter Information, um elektrische Signale zu erzeugen, welche die codierte Information repräsentieren, wobei die Schaltung folgendes aufweist:
ein magnetoresistives Element und
ein Detektionsmittel zum Erfassen des Verhältnisses des Momentanwertes der Widerstandsänderung des magnetoresistiven Elements zu dem absoluten Widerstand des magnetoresistiven Elements,
dadurch gekennzeichnet, daß das Detektionsmittel folgendes aufweist:
eine erste und eine zweite Stromquelle, die mit dem magnetoresistiven Element in Reihe geschaltet sind, um in dem magnetoresistiven Element ($R_h$) einen Vormagnetisierungsstrom ($I_b$) zu erzeugen,
einen Kondensator (C1); der an das magnetoresistive Element ($R_h$) angeschaltet ist,
eine Stromsonde zum Erfassen einer Stromabweichung des Vormagnetisierungsstromes, wobei die Abweichung proportional zu der relativen Widerstandsänderung des magnetoresistiven Elements ist, die durch Exponieren des magnetoresistiven Elementes mit dem magnetischen Feld erzeugt wird, wobei die Stromsonde eine Signalspannung ($V_s$) erzeugt, die proportional zu der Abweichung ist (Figur 2A).

2. Schaltung zum Erfassen magnetischer Felder mit codierter Information, um elektrische Signale zu erzeugen, welche die codierte Information repräsentieren, wobei die Schaltung folgendes aufweist:
ein magnetoresistives Element ($R_h$) und
ein Detektionsmittel zum Erfassen des Verhältnisses des Momentanwertes der Widerstandsänderung des magnetoresistiven Elements zu dem absoluten Widerstand des magnetoresistiven Elements,
dadurch gekennzeichnet, daß das Detektionsmittel folgendes aufweist:
eine Konstantspannungsquelle $V_r$, die mit einem ersten und einem zweiten angepaßten Widerstand ($R_s$) in Reihe mit dem magnetoresistiven Element ($R_h$) geschaltet ist, um einen Vormagnetisierungsstrom durch das magnetoresistive Element ($R_h$) zu erzeugen und
ein Ferrit-Toroid (T) mit einer Primär- und einer Sekundärwicklung, wobei die Primärwicklung mit dem magnetoresistiven Element in Reihe geschaltet ist, um in der Primärwicklung Stromabweichungen zu erzeugen, die Abweichungen proportional zu der erzeugten relativen Widerstandsänderung des magnetoresistiven Elements sind, die Abweichungen an der Sekundärwicklung eine Signalspannung ($V_s$) erzeugen und die Signalspannung proportional zu den Abweichungen ist (Figur 2B).

3. Schaltung nach Anspruch 2, die ferner einen Kondensator (C1) aufweist, der an das magnetoresistive Element geschaltet ist, um Störänderungen in dem Signalstrom bei Frequenzen zu begrenzen, die höher sind, als die Grenzfrequenz, die durch die Kapazität und den Gesamtwiderstand des magnetoresistiven Elements definiert ist.

4. Schaltung zum Erfassen magnetischer Felder mit codierter Information, um elektrische Signale zu erzeugen, welche die codierte Information repräsentieren, wobei die Schaltung folgendes aufweist:
ein magnetoresistives Element,
ein Detektionsmittel zum Erfassen des Verhältnisses des Momentanwertes der Widerstandsänderung des magnetoresistiven Elements zu dem absoluten Widerstand des magnetoresistiven Elements,
dadurch gekennzeichnet, daß das Detektionsmittel folgendes aufweist:
eine Stromquelle, die mit dem magnetoresistiven Element mit einem Widerstand $R_h$ in Reihe geschaltet ist, um in dem magnetoresistiven Element einen Vormagnetisierungsstrom $I_b$ zu erzeugen und
einen Detektor zum Erfassen von Stromabweichungen von dem Vormagnetisierungsstrom, wobei die Abweichungen proportional zu der relativen Widerstandsänderung $\triangle R_h$ des magnetoresistiven Elements sind, die durch Exponieren des Elements mit den magnetischen Feldern erzeugt wird, wobei der Detektor einen Differentialverstärker (30) aufweist, um den momentanen Stromabweichungswert $I_s$ der Stromabweichungen im wesentlichen gemäß der folgenden Beziehung zu verstärken:

$$I_s \; = \; \frac{I_b \triangle R_h}{R_h}$$

wobei $I_b$ den Vormagentisierungsstrom, $R_h$ den absoluten Widerstand des magnetoresistiven Elements und $\triangle R_h$ den Momentanwert der Widerstandsänderung des magnetoresistiven Elements beim Vorhandensein des magnetischen Feldes bezeichnen und der Differentialverstärker einen Eingang, der an eine Referenzspannung geschaltet ist, und einen anderen Eingang aufweist, der in Reihe mit einem magnetoresistiven Element geschaltet ist, um eine Ausgangssignalspannung zu erzeugen, die proportional zu den Abweichungen ist und ferner einen Kondensator aufweist, der an einem Anschluß mit dem magnetoresistiven Element und mit dem anderen Eingang des Verstärkers verbunden ist und mit dem anderen Anschluß an die Referenzspannung geschaltet sind (Figur 3 und 4).

5. Schaltung zum Erfassen magnetischer Felder mit codierter Information, um elektrische Signale zu erzeugen, welche die codierte Information repräsentieren, wobei die Schaltung folgendes aufweist:
ein magnetoresistives Element,
ein Detektionsmittel zum Erfassen des Verhältnisses des Momentanwertes der Widerstandsänderung des magnetoresistiven Elements zu dem absoluten Widerstand $R_h$ des magnetoresistiven Elements,
dadurch gekennzeichnet, daß das Detektionsmittel folgendes aufweist:
eine gesteuerte Konstantstromquelle, die mit dem magnetoresistiven Element verbunden ist, um durch dieses einen Strom $I_b$ zu erzeugen,
einen Detektor zum Erfassen von Abweichungen der Spannung an $R_h$ von der konstanten Spannung $V_b$, die von einer Konstantspannungsquelle (50) geliefert wird, wobei die Abweichungen proportional zu der relativen Widerstandsänderung des magnetoresistiven Elements sind, die durch Exponieren des Elements mit den magnetischen Feldern erzeugt wird, der Detektor einen Spannungsverstärker (70) aufweist, um den Momentanwert $V_s$ der Abweichungen zu verstärken, und ferner eine Rückkopplungsschleife (60) für eine Vorspannung aufweist, um die stationäre Spannung an den Eingängen des Spannungsverstärkers im wesentlichen gemäß der folgenden Beziehung zu minimieren,

$$V_s \; = \; \frac{V_b \triangle R_h}{R_h}$$

wobei $V_b$ die von der Konstantspannungsquelle (50) gelieferte Spannung, $R_h$ den absoluten Widerstand des magnetoresistiven Elements und $\triangle R_h$ den Momentanwert der Widerstandsänderung des magnetoresistiven Elements beim Vorhandensein des magnetischen Feldes bezeichnen (Figur 5).

6.  Schaltung nach Anspruch 5, bei welcher das Detektionsmittel eine Modellreferenz mit einer Stromquelle aufweist, die in Reihe mit einem Widerstand ($R_r$) geschaltet ist, um an dem magnetoresistiven Element einen Referenzspannungspegel ($V_b$) für die Vorspannung zu erzeugen.

7.  Schaltung nach Anspruch 6, bei welcher die Modellreferenz ferner einen Kondensator (C) aufweist, der an den Widerstand geschaltet ist, um durch den Widerstand ($R_r$) erzeugte Störänderungen der Spannung zu verringern.

8.  Schaltung nach Anspruch 7, bei welcher der Spannungsverstärker (70) zwei Eingänge aufweist und das Detektionsmittel ferner eine Rückkopplungsschleife für eine Vorspannung aufweist, um die stationäre Spannung an den Eingängen des Spannungsverstärkers (70) zu minimieren, wobei die Rückkopplungsschleife (60) für eine Vorspannung folgendes aufweist: eine Quelle für einen veränderlichen Strom, die mit dem magnetoresistiven Element in Reihe geschaltet ist, einen Komparator, um den Strom aus der Quelle für einen veränderlichen Strom entsprechend der Änderungen der Spannung an den Eingängen des Spannungsverstärkers (70) zu ändern, und ein Tiefpaßfilter (63), das zwischen dem Ausgang des Komparators und dem Steuereingang der Quelle für einen veränderlichen Strom geschaltet ist, um die Bandbreite des Frequenzganges der Rückkopplungsschleife (60) für eine Vorspannung zu begrenzen.

## Revendications

1.  Circuit de détection de champs magnétiques portant une information codée, pour produire des signaux électriques représentant l'information codée, le circuit comprenant :
    un élément magnétorésistif ; et
    des moyens de détection pour détecter le rapport de la valeur instantanée du changement de la résistance de l'élément magnétorésistif à la résistance absolue de l'élément magnétorésistif ;
    caractérisé en ce que les moyens de détection comprennent :
    une première et une deuxième sources de courant connectées en série avec l'élément magnétorésistif pour engendrer un courant de polarisation ($I_b$) dans l'élément magnétorésistif ($R_h$) ;
    un condensateur (C1) connecté aux bornes de l'élément magnétorésistif ($R_h$) ;
    une sonde de courant pour détecter une déviation de courant du courant de polarisation, la déviation étant proportionnelle au changement de résistance relative de l'élément magnétorésistif produit par l'exposition de l'élément magnétorésistif au champ magnétique, la sonde de courant engendrant une tension de signal ($V_s$) proportionnelle à la déviation (figure 2A).

2.  Circuit de détection de champs magnétiques portant une information codée, pour produire des signaux électriques représentant l'information codée, le circuit comprenant :
    un élément magnétorésistif ($R_h$) ; et
    des moyens de détection pour détecter le rapport de la valeur instantanée du changement de la résistance de l'élément magnétorésistif à la résistance absolue de l'élément magnétorésistif ;
    caractérisé en ce que les moyens de détection comprennent:
    une source de tension constante ($V_r$) connectée à une première et une deuxième résistances accordées ($R_s$) en série avec l'élément magnétorésistif ($R_h$), pour engendrer un courant de polarisation à travers l'élément magnétorésistif ($R_h$) ; et
    un toroïde en ferrite (T) ayant des enroulements primaire et secondaire, l'enroulement primaire étant connecté en série avec l'élément magnétorésistif pour engendrer des déviations de courant dans l'enroulement primaire, les déviations étant proportionellees au changement de résistance relative de l'élément magnétorésistif ainsi produit, les déviations engendrant une tension de signal ($V_s$) aux bornes de l'enroulement secondaire, la tension de signal étant proportionnelle aux déviations (figure 2B).

3.  Circuit suivant la revendication 2, comprenant en outre un condensateur (C1) connecté aux bornes de l'élément magnétorésistif pour limiter les variations de courant de signal parasites,aux fréquences supérieures à la fréquence de point de coupure définie par la valeur de capacité et la valeur de résistance totale de l'élément magnétorésistif.

4.  Circuit de détection de champs magnétiques portant une information codée, pour produire des signaux électriques représentant l' information codée, le circuit comprenant :
    un élément magnétorésistif ;
    des moyens de détection pour détecter le rapport de la valeur instantanée du changement de la résistance de l'élément magnétorésistif à la résistance absolue de l'élément magnétorésistif ;

caractérisé en ce que les moyens de détection comprennent:

une source de courant connectée en série avec l'élément magnétorésistif ayant une résistance $R_h$ , pour engendrer un courant de polarisation $I_b$ dans l'élément magnétorésistif ; et

un détecteur pour détecter les déviations de courant relatives au courant de polarisation, les déviations étant proportionnelles au changement de résistance relative $\Delta R_h$ de l'élément magnétorésistif produit par exposition de l'élément aux champs magnétiques, le détecteur comprenant un amplificateur différentiel (30) pour amplifier la valeur instantanée des déviations de courant, $I_s$ , sensiblement conformément à la relation

$$ I_s \;\; = \;\; \frac{I_b \;\; \Delta R_h}{R_h} $$

dans laquelle $I_b$ est le courant de polarisation, $R_h$ est la résistance absolue de l'élément magnétorésistif et $\Delta R_h$ est lavaleur instantanée du changement de la résistance de l'élément magnétorésistif en présence du champ magnétique, l'amplificateur différentiel ayant une entrée connectée à une tension de référence et l'autre entrée connectée en série avec l'élément magnétorésistif pour engendrer une tension de signal de sortie qui est proportionnelle aux déviations, et comprenant en outre un condensateur dont une borne est connectée à l'élément magnétorésistif et à ladite autre entrée de l'amplificateur et dont l'autre borne est connectée à la tension de référence (figures 3 et 4).

5. Circuit de détection de champs magnétiques portant une information codée, pour produire des signaux électriques représentant l'information codée, le circuit comprenant :

un élément magnétorésistif ;

des moyens de détection pour détecter le rapport de la valeur instantanée du changement de la résistance de l'élément magnétorésistif à la résistance absolue de l'élément magnétorésistif $R_h$ ;

caractérisé en ce que les moyens de détection comprennent:

une source de courant constant réglé, connectée à l'élément magnétorésistif pour engendrer un courant ($I_b$) à travers ce dernier ;

un détecteur pour détecter les déviations de la tension aux bornes de $R_h$ par rapport à la tension constante $V_b$ fournie par une source de tension constante (50), les déviations étant proportionnelles au changement de résistance relative de l'élément magnétorésistif produit par exposition de l'élément aux champs magnétiques, le détecteur comprenant un amplificateur de tension (70) pour amplifier la valeur instantanée $V_s$ des déviations, et comprenant en outre une boucle de réaction de polarisation (60) pour minimiser la tension en régime établi entre les entrées de l'amplificateur de tension, sensiblement conformément à la relation

$$ V_s \;\; = \;\; \frac{V_b \; \Delta R_h}{R_h} $$

dans laquelle $V_b$ est la tension fournie par la source de tension constante (50), $R_h$ est la résistance absolue de l'élément magnétorésistif et $\Delta R_h$ est la valeur instantanée du changement de la résistance de l'élément magnétorésistif en présence du champ magnétique (figure 5).

6. Circuit suivant la revendication 5,dans lequel les moyens de détection comprennent une référence de modèle ayant une source de courant connectée en série avec une résistance ($R_r$ ) afin d'engendrer un niveau de tension de référence ($V_b$) pour la tension de polarisation aux bornes de l'élément magnétorésistif.

7. Circuit suivant la revendication 6, dans lequel la référence de modèle comprend en outre un condensateur (C) connecté aux bornes de la résistance pour réduire les variations de tension parasites produites par la résistance ($R_r$).

8. Circuit suivant la revendication 7, dans lequel l'amplificateur de tension (70) comporte deux entrées, et les moyens de détection comprennent en outre une boucle de réaction de polarisation pour minimiser la tension en régime établi entre les entrées de l'amplificateur de tension (70), la boucle de réaction de polarisation (60) comprenant une source de courant variable connectée en série avec l'élément magnétorésistif, un comparateur pour faire varier le courant de la source de courant variable en réponse aux variations de la tension entre les entrées de l'amplificateur de tension (70), et un filtre passe-bas (63) branché entre la sortie du comparateur et l'entrée de commande de la source de courant variable, pour limiter la largeur de bande de réponse de fréquence de la boucle de réaction de polarisation (60).

PRIOR ART

FIG. 1

FIG. 2A

FIG. 2B

FIG. 3

EP 0 215 270 B1

FIG. 4

FIG. 5